# EUROPÄISCHE PATENTSCHRIFT

(11) **EP 2 810 346 B1**
(45) Veröffentlichungstag und Bekanntmachung des Hinweises auf die Patenterteilung: **02.11.2016**
(21) Anmeldenummer: 12808737.6
(22) Anmeldetag: 10.12.2012
(51) Int. Cl.: H01S 5/026, H01S 5/10, H01S 5/14, H01S 5/02, H01S 5/022, H01S 5/068

(54) **ABSTIMMBARER DBR-LASER UND VERFAHREN ZUM BETREIBEN EINES ABSTIMMBAREN DBR-LASERS**
TUNABLE DBR LASER AND METHOD OF OPERATING A TUNABLE DBR LASER
LASER DBR ACCORDABLE ET PROCÉDÉ PERMETTANT DE FAIRE FONCTIONNER UN LASER DBR ACCORDABLE

(30) Priorität: 30.01.2012 DE 102012002077
(43) Veröffentlichungstag der Anmeldung: 10.12.2014
(73) Patentinhaber: Fraunhofer-Gesellschaft zur Förderung der angewandten Forschung e.V., 80686 München (DE)
(72) Erfinder: SCHELL, Martin, 10437 Berlin (DE); RUNGE, Patrick, 14193 Berlin (DE)
(74) Vertreter: Pfenning, Meinig & Partner mbB
(86) Internationale Anmeldenummer: PCT/EP2012/074919
(87) Internationale Veröffentlichungsnummer: WO 2013/113437

(56) Entgegenhaltungen:
- WO-A1-2007/107187
- US-A1- 2010 142 567
- US-A1- 2011 267 676
- WESSTROM J -O ET AL: "Design of a widely tunable modulated grating Y-branch laser using the additive Vernier effect for improved super-mode selection", 2002 IEEE 18TH INTERNATIONAL SEMICONDUCTOR LASER CONFERENCE. CONFERENCE DIGEST (CAT. NO.02CH37390) IEEE PISCATAWAY, NJ, USA, 2002, Seiten 99-100, XP002696058, ISBN: 0-7803-7598-X

## Beschreibung

Die Erfindung betrifft einen stimmbaren DBR-Laser nach dem Oberbegriff des Hauptanspruchs und ein Verfahren zum Betreiben eines stimmbaren DBR-Lasers.

Zur Selektion und/oder zur Stabilisierung einer Emissionswellenlänge eines Lasers ist die Verwendung wellenlängenselektiver Reflektoren bekannt. Derartige Reflektoren können einen optischen Resonator des Lasers an einem Ende des Resonators begrenzen und beispielsweise als Bragg-Reflektoren, auch DBR (distributed Bragg reflector) genannt, ausgebildet sein. Solche Laser werden daher als DBR-Laser bezeichnet. Bragg-Reflektoren umfassen gewöhnlich eine Vielzahl dielektrischer Schichten mit alternierendem Brechungsindex, wobei ein Reflexionsspektrum des Bragg-Reflektors durch eine Dicke und durch Brechungsindizes der dielektrischen Schichten bestimmt ist. Die Reflektivität des Bragg-Reflektors hat ein Maximum, wenn eine Wellenlänge des einfallenden Lichtes gleich dem Vierfachen einer optischen Weglänge einer einzelnen der Schichten des Reflektors ist.

Die Wellenlänge des Reflexionsmaximums eines Bragg-Reflektors kann beispielsweise durch Veränderung der Temperatur oder durch anlegen eines elektrischen Feldes und eine damit verbundene Änderung eines effektiven Brechungsindexes veränderbar sein. Dadurch kann eine Emissionswellenlänge von aus dem Stand der Technik bekannten DBR-Lasern innerhalb eines Wellenlängenbereichs, der typischerweise allerdings eng begrenzt ist, verstimmt werden. Ein Laser, bei dem ein wellenlängenselektives Element als Bragg-Reflektor ausgebildet und bei dem ein Brechungsindex eines Materials des Bragg-Reflektors veränderbar ist, ist beispielsweise in der Druckschrift EP 2 169 788 A1 gezeigt. Aufgrund der nötigen Temperaturstabilisierung des Reflektors ist ein schnelles Verstellen zwischen verschiedenen Emissionswellenlängen bei einem solchen Laser aber nur eingeschränkt möglich. Außerdem wäre es vorteilhaft, wenn der Wellenlängenbereich, innerhalb dessen die Emissionswellenlänge des Lasers veränderbar ist, vergrößert werden könnte.

Abstimmbare Laser sind aus US 2011/267676 A1 ; US 2010/142567 A1 und WO 2007/107187 A1 bekannt.

Der vorliegenden Erfindung liegt somit die Aufgabe zugrunde, einen Laser zu entwickeln, bei dem eine Emissionswellenlänge innerhalb möglichst weiter Grenzen und möglichst schnell verstellbar ist. Entwickelt werden soll außerdem ein Verfahren zum Betreiben eines derartigen Lasers mit einer jeweils möglichst genau definierten und aus einem möglichst weiten Wellenlängenbereich frei wählbaren Emissionswellenlänge.

Diese Aufgabe wird gelöst durch einen stimmbaren DBR-Laser gemäß Anspruch 1 und durch ein Verfahren zum Betreiben eines derartigen DBR-Lasers nach Anspruch 9. Vorteilhafte Ausgestaltungen der Erfindung ergeben sich mit den Merkmalen der Unteransprüche.

Vorgeschlagen wird also ein stimmbarer DBR-Laser, umfassend eine ein aktives Material enthaltende Verstärkersektion, einen teilreflektierenden optischen Ausgang, eine Verbindungssektion, die sich an einem dem Ausgang des DBR-Lasers gegenüberliegenden Ende der Verstärkersektion an die Verstärkersektion anschließt, und einen durch die Verbindungssektion optisch mit der Verstärkersektion gekoppelten wellenlängenselektiven Reflektor. Der DBR-Laser weist mindestens einen weiteren wellenlängenselektiven Reflektor auf, der ebenfalls durch die Verbindungssektion optisch mit der Verstärkersektion gekoppelt ist, und die Verbindungssektion enthält mindestens einen MMI-Koppler, wobei die wellenlängenselektiven Reflektoren sich durch unterschiedliche Reflexionsspektren voneinander unterscheiden und mit jeweils einem von mehreren Ausgängen des mindestens einen MMI-Kopplers verbunden sind, wobei die Verbindungssektion mehrere nebeneinander verlaufende Wellenleiter umfasst, so dass von der Verstärkersektion zu jedem der Reflektoren jeweils verschiedene optische Wege durch den mindestens einen MMI-Koppler und jeweils einen der Wellenleiter führen, und wobei in einem Verlauf mindestens eines dieser Wellenleiter ein Phasenschieber angeordnet ist, so dass der DBR-Laser durch Ansteuerung des mindestens einen Phasenschiebers umschaltbar ist zwischen verschiedenen Resonatoren, die durch jeweils einen der wellenlängenselektiven Reflektoren begrenzt sind.

Vorgeschlagen wird außerdem ein Verfahren zum Betreiben eines derartigen DBR-Lasers, wobei der mindestens eine Phasenschieber derart angesteuert wird, dass in der Verstärkersektion erzeugtes und von der Verstärkersektion aus in die Verbindungssektion eingekoppeltes Licht nur auf genau einen der wellenlängenselektiven Reflektoren gelenkt wird, so dass der DBR-Laser Laserlicht einer Emissionswellenlänge emittiert, die in Abhängigkeit vom Reflexionsspektrum dieses ausgewählten Reflektors aus einem breiteren Gewinnspektrum der Verstärkersektion selektiert wird.

Der Erfindung liegt der Gedanke zugrunde, einen optischen Schalter in Gestalt des MMI-Kopplers in Verbindung mit dem mindestens einen Phasenschieber zu realisieren, mithilfe dessen jeweils einer der verschiedenen optischen Resonatoren des Lasers auswählbar ist, indem das in der Verstärkersektion erzeugte Licht jeweils nur auf genau einen der wellenlängenselektiven Reflektoren gelenkt wird. In Abhängigkeit vom Reflexionsspektrum des den ausgewählten Resonator begrenzenden wellenlängenselektiven Reflektors ist damit die Emissionswellenlänge des DBR-Lasers auswählbar und/oder einstellbar. Der Wellenlängenbereich, innerhalb dessen die Emissionswellenlänge des Lasers einstellbar ist, ist somit lediglich durch ein Gewinnspektrum (Gain-Spektrum) des aktiven Materials beschränkt. Mit dem durch den MMI-Koppler und den mindestens einen Phasenschieber realisierten optischen Schalter kann schnell und zuverlässig zwischen den verschieden Resonatoren umgeschaltet werden.

In der Verstärkersektion erzeugtes Licht durchläuft den mindestens einen MMI-Koppler bei einem vollständigen Umlauf in dem jeweils ausgewählten optischen Resonator typischerweise mindestens zweimal. An die Verbindungssektion mit dem mindestens einen MMI-Koppler und dem mindestens einen Phasenschieber wird also die Anforderung gestellt, dass das in der Verstärkersektion erzeugte Licht diese in zwei entgegengesetzten Richtungen durchlaufen können muss, um dann wieder in die Verstärkersektion eingekoppelt zu werden. Durch eine entsprechende Einstellung des mindestens einen Phasenschiebers lässt sich diese Bedingung erfüllen, indem Phasenbeziehungen für zwei entgegengesetzte Propagationsrichtungen des in der Verstärkersektion erzeugten Lichtes durch den MMI-Koppler berücksichtigt werden.

Mit dem Begriff "stimmbar" ist in Bezug auf den vorliegend beanspruchten Gegenstand gemeint, dass die Emissionswellenlänge des DBR-Lasers veränderbar ist, ohne dass notwendigerweise eine stufenlose Verstellbarkeit gefordert wird. Am optischen Ausgang des DBR-Lasers ist also Laserlicht der durch den jeweils ausgewählten wellenlängenselektiven Reflektor definierten und durch Umschalten zwischen den verschiedenen Reflektoren verstellbaren Emissionswellenlänge auskoppelbar. Die so auswählbaren Emissionswellenlängen können sich dabei in relativ weiten Grenzen voneinander unterscheiden, insbesondere wenn die Verstärkersektion ein möglichst breitbandiges Gewinnspektrum hat. Typischerweise ist die optische Kopplung zwischen der Verstärkersektion und dem mindestens einen MMI-Koppler sowie zwischen dem mindestens einen MMI-Koppler und den wellenlängenselektiven Reflektoren ganz oder teilweise durch optische Wellenleiter realisiert, die zum Beispiel als auf einem Substrat angeordnete Rippenwellenleiter oder als optische Fasern ausgebildet sein können. Ein Durchmesser der vorzugsweise einmodigen Wellenleiter kann kleiner 10 µm sein.

Vorzugsweise ist mindestens einer der wellenselektiven Reflektoren als Bragg-Reflektor ausgebildet. Bragg-Reflektoren zeichnen sich durch ein besonders schmalbandiges Reflexionsspektrum aus, so dass der DBR-Laser Laserlicht mit einer besonders schmalen spektralen Linienbreite zu emittieren eingerichtet ist. Dies ist für viele Anwendungen vorteilhaft.

Der MMI-Koppler - MMI steht für Multi Mode Interference - kann in einfacher Weise als Wellenleiterstruktur mit mehreren Ein- und Ausgängen realisiert sein, die gegenüber einfachen Wellenleitern so aufgeweitet ist, dass mehrere Moden darin Platz finden. Der MMI-Koppler weist wenigstens einen Eingang auf, an dem das in der Verstärkersektion erzeugte Licht vorzugsweise mittels eines Single-Mode-Wellenleiters in den MMI-Koppler einkoppelbar ist. Der MMI-Koppler kann einschichtig oder mehrschichtig ausgebildet sein. Vorzugsweise ist er monolithisch mit einem Substrat ausgebildet, von dem er typischerweise durch eine optische Pufferschicht getrennt ist.

Gewöhnlich sind der mindestens eine Eingang des MMI-Kopplers einerseits und die mehreren Ausgänge des MMI-Kopplers andererseits auf einander gegenüberliegenden Seiten des MMI-Kopplers angeordnet. Vorzugsweise sind die Ausgänge des MMI-Kopplers relativ zueinander so angeordnet, dass an den unterschiedlichen Ausgängen des MMI-Kopplers aus dem MMI-Koppler ausgekoppeltes Licht relativ zu einander eine definierte Phasendifferenz aufweist. Das ergibt sich dadurch, dass die verschiedenen Moden in einer durch die Geometrie des MMI-Kopplers definierten Weise interferieren.

Der mindestens eine Phasenschieber ist vorzugsweise eingerichtet, eine optische Weglänge desjenigen der nebeneinander verlaufenden Wellenleiter, in dessen Verlauf er angeordnet ist, zu verändern. Dadurch ist eine optische Phase eines in diesem Wellenleiter propagierenden Anteils in der Verstärkersektion erzeugten Lichtes durch Ansteuerung des mindestens einen Phasenschiebers veränderbar, z. B. um Δφ mit 0≤|Δφ| ≤π, wobei Δφ die Änderung der optischen Phase bezeichnen soll. Typischerweise wird diese Phasenänderung durch Veränderung eines effektiven Brechungsindex wenigstens in einem Abschnitt dieses Wellenleiters bewirkt. Vorzugsweise ist in jedem der nebeneinander verlaufenden Wellenleiter ein Phasenschieber angeordnet, wobei die Phasenschieber dann unabhängig voneinander ansteuerbar sein können. Eine Lichtintensität von an den mit den wellenlängenselektiven Reflektoren verbundenen Ausgängen des entsprechenden MMI-Kopplers ausgekoppeltem Licht ist durch Ansteuerung des mindestens einen Phasenschiebers kontrollierbar. Insbesondere kann der mindestens eine Phasenschieber daher derart angesteuert werden, dass das in der Verstärkersektion erzeugte Licht jeweils an nur genau einem der wellenlängenselektiven Reflektoren ankommt. Typischerweise ist wenigstens einer der nebeneinander verlaufenden Wellenleiter als Single-Mode-Wellenleiter ausgebildet. Vorzugsweise gilt dies für alle der nebeneinander verlaufenden Wellenleiter. Es ist vorteilhaft, wenn im Verlauf jedes der nebeneinander verlaufenden Wellenleiter ein Phasenschieber angeordnet ist.

Das Gewinnspektrum der Verstärkersektion des DBR-Lasers, das durch das aktive Material gegeben ist, kann eine Halbwertsbreite von mehr als 10 nm, von mehr als 20 nm, mehr als 50 nm oder mehr als 100 nm aufweisen. Die wählbare Emissionswellenlänge des DBR-Lasers kann z. B. kleiner als 2000 nm, kleiner als 1500 nm, kleiner als 1000 nm, kleiner als 800 nm oder kleiner als 600 nm sein und/oder größer als 200 nm, größer als 300 nm oder größer als 400 nm sein.

Eine spezielle Ausführungsform des DBR-Lasers zeichnet sich dadurch aus, dass die Verbindungssektion einen ersten MMI-Koppler und einen zweiten MMI-Koppler enthält, wobei Ausgänge des ersten MMI-Kopplers durch die nebeneinander verlaufenden Wellenleiter mit jeweils einem von mehreren Eingängen des zweiten MMI-Kopplers verbunden sind und wobei die wellenlängenselektiven Reflektoren mit jeweils einem von mehreren Ausgängen des zweiten MMI-Kopplers verbunden sind.

Das in der Verstärkersektion erzeugte Licht ist bei dieser Ausführungsform an den mehreren Eingängen des zweiten MMI-Kopplers in den zweiten MMI-Koppler einkoppelbar, wobei relative optische Phasen des an den mehreren Eingängen des zweiten MMI-Kopplers in den zweiten MMI-Koppler eingekoppelten Lichtes mittels des mindestens einen Phasenschiebers relativ zueinander veränderbar sind. Vorzugsweise ist in einem Verlauf eines jeden der nebeneinander verlaufenden Wellenleiter, die die Ausgänge des ersten MMI-Kopplers mit den Eingängen des zweiten MMI-Kopplers verbinden, ein Phasenschieber angeordnet. Eine Anzahl von Freiheitsgraden zur Kontrolle von an den Ausgängen des zweiten MMI-Kopplers aus dem zweiten MMI-Koppler jeweils ausgekoppelten oder auskoppelbaren Lichtintensitäten wird dadurch in vorteilhafter Weise erhöht. Bei einem vollständigen Umlauf des in der Verstärkersektion erzeugten Lichtes in dem jeweils ausgewählten optischen Resonator wird jeder der beiden MMI-Koppler bei dieser Ausführungsform typischerweise genau zweimal durchlaufen, und zwar bei den beiden Durchläufen jeweils in entgegengesetzter Richtung.

Eine weitere spezielle Ausführungsform zeichnet sich dadurch aus, dass der MMI-Koppler mindestens zwei weitere Ausgänge aufweist, die den mit den wellenlängenselektiven Reflektoren verbundenen Ausgängen dieses MMI-Kopplers gegenüberliegen und die jeweils durch einen der nebeneinander verlaufenden Wellenleiter mit einem in den jeweiligen Wellenleiter zurückreflektierenden Spiegel verbunden sind, wobei die Verstärkersektion optisch mit einem Eingang dieses MMI-Kopplers gekoppelt ist, der vorzugsweise den genannten weiteren Ausgängen gegenüberliegt.

Bei dieser Ausführungsform ist normalerweise nur genau ein MMI-Koppler erforderlich, so dass der DBR-Laser besonders kompakt und raumsparend ausgebildet sein kann. Es ist vorteilhaft, wenn im Verlauf jedes der nebeneinander verlaufenden Wellenleiter ein Phasenschieber angeordnet ist. Vorzugweise sind die die Ausgänge des MMI-Kopplers mit den wellenlängenselektiven Reflektoren verbindenden Wellenleiter jeweils ganz oder wenigstens teilweise als Single-Mode-Wellenleiter ausgebildet. Wenigstens einer der Spiegel oder alle Spiegel können als Wellenleiterfacetten bzw.-enden ausgebildet sein. Diese können - müssen jedoch nicht unbedingt - verspiegelt sein. Das in der Verstärkersektion erzeugte Licht durchläuft den MMI-Koppler bei einem vollständigen Umlauf im jeweils ausgewählten optischen Resonator bei dieser Ausführungsform typischerweise genau viermal. Dabei wird das Licht nach einem ersten Durchlauf durch den MMI-Koppler vollständig oder wenigstens teilweise an mindestens einem der Spiegel reflektiert. Nach einem zweiten Durchlauf durch den MMI-Koppler wird dieses Licht dann vollständig oder wenigstens teilweise an genau einem der wellenlängenselektiven Reflektoren reflektiert. Nach einem dritten Durchlauf durch den MMI-Koppler wird dieses Licht vollständig oder wenigstens teilweise wiederum an mindestens einem der Spiegel reflektiert. Nach einem vierten Durchlauf durch den MMI-Koppler wird das Licht dann vollständig oder wenigstens teilweise durch den Eingang des MMI-Kopplers zurück in die Verstärkersektion geleitet.

Den hier beispielhaft beschriebenen Ausführungsformen gemeinsam ist, dass das in der Verstärkersektion erzeugte Licht auf seinem Weg zum jeweils ausgewählten wellenlängenselektiven Reflektor zweimal einen MMI-Koppler zu passieren hat - entweder zweimal denselben MMI-Koppler oder zwei verschiedene MII-Koppler jeweils einmal.

Der mindestens eine MMI-Koppler kann ein N x N-Koppler sein. Dabei handelt es sich um einen MMI-Koppler, bei dem eine Anzahl von mehreren Eingängen des MMI-Kopplers gleich einer Anzahl von mehreren Ausgängen des MMI-Kopplers ist. Vorzugsweise ist der MMI-Koppler bei dieser Ausführungsform als 4 x 4 90°-Hybrid ausgebildet. Ebenso kann der oder einer der MMI-Koppler als 1 x N-Koppler ausgebildet sein.

Die Veränderbarkeit der Phase des jeweiligen Lichtanteils kann in einfacher Weise dadurch realisiert werden, dass der mindestens eine Phasenschieber ein Heizelement aufweist und/oder als elektrooptisches Element ausgebildet ist. Der effektive Brechungsindex bzw. eine optische Weglänge desjenigen der nebeneinander verlaufenden Wellenleiter, in dem der jeweilige Phasenschieber angeordnet ist, kann so und/oder durch Anlegen eines elektrischen und/oder eines magnetischen Feldes verändert werden. Zum Beispiel kann das elektrooptische Element wenigstens ein Paar von Elektroden umfassen, an denen eine elektrische Spannung anlegbar ist. Bei dieser Ausführungsform kann der Phasenschieber eine optische Phase des in der Verstärkersektion erzeugten und in dem jeweiligen Wellenleiter geführten Lichtes schnell und mit großer Genauigkeit verändern.

Eine spezielle Ausführungsform zeichnet sich dadurch aus, dass der DBR-Laser ein Halbleitersubstrat aufweist, auf dem zumindest die Verstärkersektion angeordnet ist, wobei vorzugsweise das Halbleitersubstrat und/oder mindestens ein auf dem Halbleitersubstrat angeordneter Wellenleiter und/oder der mindestens eine MMI-Koppler ganz oder zumindest teilweise aus InP oder InGaAsP oder InGaAlAs gebildet ist.

Bei dem Halbleitersubstrat kann es sich beispielsweise um einen Mikrochip handeln. Neben der Verstärkersektion können auch der mindestens eine MMI-Koppler und/oder die wellenlängenselektiven Reflektoren auf dem Halbleitersubstrat angeordnet sein. Insbesondere können das Halbleitersubstrat und die Verstärkersektion und/oder der mindestens eine auf dem Halbleitersubstrat angeordnete Wellenleiter und/oder der mindestens eine auf dem Halbleitersubstrat angeordnete MMI-Koppler und/oder die auf dem Halbleitersubstrat angeordneten wellenlängenselektiven Reflektoren monolithisch, also auf einem einzigen Substrat ausgebildet sein. Diese Ausführungsform erlaubt eine besonders kompakte Ausgestaltung des DBR-Lasers bzw. wenigstens der auf dem Halbleitersubstrat angeordneten Komponenten des DBR-Lasers. Beispielsweise lässt sich der DBR-Laser bei dieser Ausführungsform in vorteilhafter Weise in eine ebenfalls auf dem Halbleitersubstrat angeordnete optische und/oder optoelektronische Schaltung integrieren. Anstelle des Halbleitersubstrats oder zusätzlich zu diesem kann der DBR-Laser auch ein Substrat umfassen, das ganz oder wenigstens teilweise aus einem Polymer gebildet ist.

Eine weitere spezielle Ausführungsform zeichnet sich dadurch aus, dass die Verstärkersektion und die Verbindungssektion auf unterschiedlichen Substraten angeordnet sind, wobei vorzugsweise ein der Verbindungssektion zugewandtes Ende der Verstärkersektion und/oder ein der Verstärkungssektion zugewandtes Ende der Verbindungssektion entspiegelt ist. So ist es z. B möglich, in einer sogenannten Hybridintegration die Verstärkersektion auf einem Halbleitersubstrat, alle übrigen genannten Komponenten jedoch auf einem Polymersubstrat anzuordnen.

Die Tatsache, dass bei dieser Ausführungsform die Verstärkersektion und die Verbindungssektion auf unterschiedlichen Substraten angeordnet sind, gestattet eine Vielzahl von Anordnungen der unterschiedlichen Komponenten des DBR-Lasers. Durch das Verspiegeln des der Verbindungssektion zugewandten Endes der Verstärkersektion und/oder des der Verstärkersektion zugewandten Endes der Verbindungssektion werden Leistungsverluste, die beim Einkoppeln von Licht aus der Verstärkersektion in die Verbindungssektion oder aus der Verbindungssektion in die Verstärkersektion auftreten können, minimiert. Bei dieser Ausführungsform sind die Verstärkersektion und die Verbindungssektion vorzugsweise durch einen Wellenleiter optisch gekoppelt, der z. B. als optische Faser ausgebildet sein kann.

Als aktives Material können alle üblichen laserfähigen Halbleitermaterialien verwendet werden, beispielsweise kann das aktive InP und/oder InGaAsP und/oder InGaAlAs enthalten.

Bei dieser Ausführungsform ist die Verstärkersektion also in Form eines Halbleiterkristalls, einer Halbleiterdiode oder eines anderen Festkörperkristalls gegeben. Selbstverständlich kann das aktive Material eine Vielzahl weiterer Materialien oder Verbindungen, insbesondere eine Vielzahl weiterer Halbleiterverbindungen umfassen. Durch die Ausbildung der Verstärkersektion des DBR-Lasers als Halbleiterlaser, als Diodenlaser oder als Festkörperlaser ist ein Gewinnspektrum der Verstärkersektion bzw. des aktiven Materials mit großer Flexibilität wählbar und/oder einstellbar. Der DBR-Laser ist damit für eine Vielzahl von Anwendungen einsetzbar.

Eine Reflektivität des teilreflektierenden optischen Ausgangs bei einer Emissionswellenlänge des DBR-Lasers kann so gewählt werden, dass sie wenigstens 75 Prozent und/oder höchstens 95 Prozent beträgt. Durch entsprechende Auswahl oder Einstellung der Reflektivität des teilreflektierenden optischen Ausgangs ist zum Beispiel eine Leistung des aus dem DBR-Laser ausgekoppelten Laserlichts einstellbar.

Eine weitere spezielle Ausführungsform zeichnet sich dadurch aus, dass mindestens einer der wellenlängenselektiven Reflektoren stufenlos stimmbar ist, so dass das Reflexionsspektrum dieses Reflektors veränderbar ist und zumindest in gewissen Grenzen zu größeren oder kleineren Wellenlängen hin verschoben werden kann.

Zum stufenlosen Stimmen des mindestens einen stufenlos stimmbaren wellenlängenselektiven Reflektors kann ein Verstimmelement vorgesehen sein. Dieses kann ein Heizelement und/oder ein elektrooptisches Element umfassen und vorzugsweise unmittelbar am jeweiligen wellenlängenselektiven Reflektor angeordnet sein. Neben dem Umschalten zwischen den verschiedenen optischen Resonatoren ist es bei dieser Ausführungsform also darüber hinaus möglich, die Emissionswellenlänge des Lasers durch Veränderung des Reflexionsspektrums des stufenlos stimmbaren Reflektors zu verändern. Der DBR-Laser ist damit noch flexibler einsetzbar und an spezielle Anwendungen anpassbar. Insbesondere können die wellenlängenselektiven Reflektoren derart ausgebildet sein, dass die Wellenlängenbereiche, innerhalb derer die verschiedenen wellenlängenselektiven Reflektoren jeweils verstimmbar sind, einander in Randbereichen überlappend und zusammen genommen das gesamte Gewinnspektrum der Verstärkersektion oder wenigstens einen möglichst großen Bereich des Gewinnspektrums der Verstärkersektion überdecken. Durch Ansteuern des mindestens einen Phasenschiebers und das damit bewirkte Umschalten zwischen den verschiedenen Resonatoren einerseits und durch Verstimmen der Reflexionsspektren der wellenlängenselektiven Reflektoren andererseits sind damit stufenlos alle oder wenigstens ein Großteil der durch das aktive Material verstärkbaren Lichtwellenlängen als Emissionswellenlänge des DBR-Lasers einstellbar.

Ausführungsbeispiele der Erfindung sind in den Zeichnungen dargestellt und werden anhand der folgenden Beschreibung näher erläutert. Es zeigen
- Figur 1: eine erste Ausführungsform eines DBR-Lasers, der zwei MMI-Koppler umfasst, wobei eine Verstärkersektion und eine Verbindungssektion auf demselben Halbleitersubstrat angeordnet sind,
- Figur 2: eine zweite Ausführungsform des DBR-Lasers, bei der die Verstärkersektion und die Verbindungssektion jeweils auf unterschiedlichen Substraten angeordnet sind, sowie
- Figur 3: eine dritte Ausführungsform des DBR-Lasers, wobei der DBR-Laser genau einen MMI-Koppler umfasst.

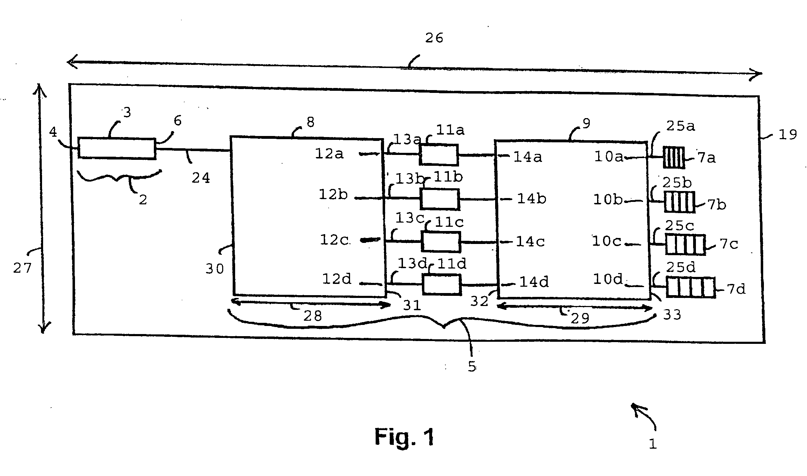

Figur 1 zeigt eine erste Ausführungsform eines stimmbaren DBR-Lasers 1. Eine Verstärkersektion 2 des DBR-Lasers 1 umfasst ein aktives Material 3, das in Form einer InP/InGaAsP-Diode gegeben ist. Bei einer leicht abgewandelten Ausführungsform kann das aktive Material 3 lnGaAlAs enthalten. Ein Gewinnspektrum des aktiven Materials 3 hat ein Maximum bei einer Wellenlänge von 1550 nm und eine Halbwertsbreite von etwa 40 nm. Ein teilreflektierender optischer Ausgang 4 des Lasers 1 ist durch eine Grenzfläche des aktiven Materials 3 gegeben. Eine Reflektivität des optischen Ausgangs 4 beträgt für Licht in einem Wellenlängenbereich von 1500 nm bis 1600 nm zwischen 75% und 95%. An einem dem optischen Ausgang 4 des Lasers 1 gegenüberliegenden Ende 6 der Verstärkersektion 2 schließt sich eine Verbindungssektion 5 des DBR-Lasers 1 an die Verstärkersektion 2 an. Die Verbindungssektion 5 umfasst einen ersten MMI-Koppler 8 und einen zweiten MMI-Koppler 9. Der erste MMI-Koppler 8 ist ein 4 x 4-Koppler, von dem nur ein Eingang 23 belegt ist und der außerdem vier Ausgänge 12a bis 12d aufweist. Der zweite MMI-Koppler 9 ist ebenfalls ein 4 x 4-Koppler mit vier Eingängen 14a bis 14d und vier Ausgängen 10a bis 10d. Das Ende 6 der Verstärkersektion 2 ist über einen Single-Mode-Wellenleiter 24 mit den Eingang 23 des ersten MMI-Kopplers 8 verbunden.

Die Ausgänge 12a bis 12d des ersten MMI-Kopplers 8 sind durch Single-Mode-Wellenleiter 13a bis 13d mit jeweils einem der Eingänge 14a bis 14d des zweiten MMI-Kopplers 9 verbunden. In einem Verlauf jedes der Wellenleiter 13a bis 13d ist jeweils einer von vier Phasenschiebern 11a bis 11d angeordnet. Im vorliegenden Beispiel sind die Phasenschieber 11a bis 11d dabei jeweils als elektrooptisches Element ausgebildet. Insbesondere umfassen die Phasenschieber 11a bis 11d jeweils ein Elektrodenpaar, das unmittelbar an dem entsprechenden Wellenleiter angeordnet ist und an dem jeweils eine elektrische Spannung anlegbar ist. Durch das Anlegen der elektrischen Spannung an den Elektroden der Phasenschieber 11a bis 11d ist ein effektiver Brechungsindex der Wellenleiter 13a bis 13d jeweils bereichsweise veränderbar. Mit anderen Worten sind die Phasenschieber 11a bis 11d jeweils eingerichtet, eine optische Weglänge der Wellenleiter 13a bis 13d für in der Verstärkersektion 2 erzeugtes und in den Wellenleitern 13a bis 13d geführtes Licht stufenlos zu verändern. Auf diese Weise sind relative optische Phasen des in der Verstärkersektion 2 erzeugten und in den Wellenleitern 13a bis 13d geführten Lichtes mittels der Phasenschieber 11a bis 11d jeweils unabhängig voneinander veränderbar. Bei einer leichten Abwandlung der hier gezeigten Ausführungsform können die Phasenschieber 11a bis 11d alternativ oder zusätzlich zu den elektrooptischen Elementen auch jeweils ein Heizelement aufweisen. Auch diese Heizelemente sind dann eingerichtet, den Brechungsindex der Wellenleiter 13a bis 13d jeweils wenigstens bereichsweise zu verändern und damit eine Veränderung der optischen Weglänge der Wellenleiter 13a bis 13d für das in der Verstärkersektion 2 erzeugte und in den Wellenleitern 13a bis 13d geführte Licht zu bewirken.

Die Ausgänge 10a bis 10d des zweiten MMI-Kopplers 9 sind jeweils über Single-Mode-Wellenleiter 25a bis 25d mit jeweils genau einem von vier verschiedenen wellenlängenselektiven Reflektoren 7a bis 7d verbunden. Die Single-Mode-Wellenleiter 25a bis 25d sind also jeweils eingerichtet, in der Verstärkersektion 2 erzeugtes und an den Ausgängen 10a bis 10d aus dem zweiten MMI-Koppler 9 ausgekoppeltes Licht jeweils auf genau einen der Reflektoren 7a bis 7d zu lenken und das an den Reflektoren 7a bis 7d in den jeweiligen Single-Mode-Wellenleiter 25a, 25b, 25c bzw. 25d zurückreflektierte Licht zurück zu den Ausgängen 10a bis 10d zu führen und dort wieder in den MMI-Koppler 9 einzukoppeln. Die wellenlängenselektiven Reflektoren 7a bis 7d sind also jeweils durch die Verbindungssektion 5 optisch mit der Verstärkersektion 2 gekoppelt.

Die wellenlängenselektiven Reflektoren 7a bis 7d sind im vorliegenden Beispiel jeweils als Bragg-Reflektor ausgebildet. Sie umfassen also jeweils eine Vielzahl von dielektrischen Schichten mit alternierendem Brechungsindex. Die Reflektoren 7a bis 7d sind dabei in den jeweiligen Single-Mode-Wellenleiter 25a, 25b, 25c bzw. 25d integriert, an dessen Ende sie angeordnet sind. Dabei sind die Reflektoren 7a bis 7d derart ausgebildet, dass sich ihre Reflexionsspektren voneinander unterscheiden. Insbesondere liegen Reflexionsmaxima der Reflexionsspektren der Reflektoren 7a bis 7d jeweils bei unterschiedlichen Wellenlängen. Zusätzlich sind die wellenlängenselektiven Reflektoren 7a bis 7d stufenlos stimmbar, so dass ihre Reflexionsspektren jeweils innerhalb gewisser Grenzen verschiebbar sind. Dazu ist an jedem der Reflektoren 7a bis 7d ein hier nicht gezeigtes Verstimmelement angeordnet. Die Verstimmelemente sind eingerichtet, die Brechungsindizes der dielektrischen Schichten desjenigen Bragg-Reflektors, an dem sie jeweils angeordnet sind, zu verändern und das Reflexionsmaximum des entsprechenden Reflektors dadurch zu verschieben. Im hier gezeigten Beispiel sollen die an den Reflektoren 7a bis 7d jeweils angeordneten Verstimmelemente als Heizelemente ausgebildet sein. Die an den Reflektoren 7a bis 7d angeordneten Verstimmelemente sind unabhängig voneinander ansteuerbar, so dass die Reflexionsspektren der Reflektoren 7a bis 7d unabhängig voneinander stufenlos veränderbar sind.

Im vorliegenden Beispiel ist ein erstes Reflexionsmaximum des ersten Reflektors 7a in einem Wellenlängenbereich von 1530 nm bis 1540 nm stufenlos verstimmbar. Ein zweites Reflexionsmaximum des zweiten Reflektors 7b ist in einem zweiten Wellenlängenbereich von 1540 nm bis 1550 nm stufenlos veränderbar. Ein drittes Reflexionsmaximum des dritten Reflektors 7c ist in einem dritten Wellenlängenbereich von 1550 nm bis 1560 nm stufenlos veränderbar. Ein viertes Reflexionsmaximum des vierten Reflektors 7d ist in einem vierten Wellenlängenbereich von 1560 nm bis 1570 nm stufenlos verstimmbar. Die Reflexionsspektren der Reflektoren 7a bis 7d sind in den genannten Wellenlängenbereichen, innerhalb derer die Reflexionsmaxima der Reflexionsspektren jeweils veränderbar sind, besonders scharf. Eine relative Halbwertsbreite Δλ_{FWHM}/λ_{MAX} der Reflexionsspektren der Reflektoren 7a bis 7d beträgt im vorliegenden Beispiel jeweils weniger als 10⁻⁷. Dabei bezeichnet Δλ_{FWHM} die Halbwertsbreite des jeweiligen Reflexionsspektrums und λ_{MAX} diejenige Wellenlänge, die dem Wert maximaler Reflektivität zugeordnet ist.

Der DBR-Laser 1 ist monolithisch ausgeführt und vollständig auf einem Halbleitersubstrat 19 aus Silizium angeordnet. Mit anderen Worten sind das aktive Material 3, die MMI-Koppler 8 und 9, die wellenlängenselektiven Bragg-Reflektoren 7a bis 7d sowie die Wellenleiter 24, 25a bis 25d und die Wellenleiter 13a bis 13d mit den Phasenschiebern 11a bis 11d auf demselben Halbleitersubstrat 19 angeordnet. Das Halbleitersubstrat 19 bildet einen Mikrochip mit einer Länge 26 von 6 mm und einer Breite 27 von 2mm. Die MMI-Koppler 8 und 9 sowie die Single-Mode-Wellenleiter 24, 13a bis 13d und 25a bis 25d sind jeweils aus InGaAlAs, InP oder InGaAsP gebildet. Durchmesser der Wellenleiter 24, 13a bis 13d und 25a bis 25d betragen jeweils 2,5 µm. Die MMI-Koppler 8 und 9 sind jeweils planar ausgebildet und haben gleiche Abmessungen. In einer in Figur 1 dargestellten Ebene sind die MMI-Koppler 8 und 9 jeweils rechteckig geformt, wobei Längen 28 und 29 der MMI-Koppler 8 und 9 jeweils etwa 1500 µm betragen. Eine zu den Längen 28 und 29 senkrechte Breite der MMI-Koppler 8 und 9 beträgt jeweils ca. 30 µm.

Die Ausgänge 12a bis 12d des MMI-Kopplers 8, die Eingänge 14a bis 14d des MMI-Kopplers 9 und die Ausgänge 10a bis 10d des MMI-Kopplers 9 sind jeweils in einer Ebene regelmäßig in äquidistanten Abständen angeordnet. Die Ausgänge 12a bis 12d des ersten MMI-Kopplers 8 sind an derselben zweiten Seite 31 des ersten MMI-Kopplers 8 angeordnet, die einer den Eingang 23 des MMI-Kopplers 8 aufweisenden ersten Seite 30 des ersten MMI-Kopplers 8 gegenüberliegt. Die Eingänge 14a bis 14d sind an einer ersten Seite 32 des zweiten MMI-Kopplers 9 angeordnet, und die Ausgänge 10a bis 10d sind an einer der ersten Seite 32 gegenüberliegenden zweiten Seite 33 des zweiten MMI-Kopplers 9 angeordnet.

Im Folgenden soll beschrieben werden, wie der DBR-Laser 1 durch Ansteuerung der Phasenschieber 11a bis 11d zwischen verschiedenen optischen Resonatoren umschaltbar ist, wobei die verschiedenen optischen Resonatoren durch die verschiedenen wellenlängenselektiven Bragg-Reflektoren 7a bis 7d begrenzt sind. Ein erster optischer Resonator wird durch den optischen Ausgang 4 und den ersten Reflektor 7a begrenzt. Ein zweiter optischer Resonator wird durch den optischen Ausgang 4 und den zweiten Reflektor 7b begrenzt. Ein dritter optischer Resonator wird durch den optischen Ausgang 4 und den dritten Reflektor 7c begrenzt. Ein vierter optischer Resonator wird durch den optischen Ausgang 4 und den vierten Reflektor 7d begrenzt.

Durch Herstellung einer Besetzungsinversion im aktiven Material 3 erzeugtes Licht wird über den Single-Mode-Wellenleiter 24 am Eingang 23 in den ersten MMI-Koppler 8 eingekoppelt. Dadurch werden im ersten MMI-Koppler 8 von einer Geometrie des ersten MMI-Kopplers 8 unterstützte optische Moden angeregt. An den Ausgängen 12a bis 12d des ersten MMI-Kopplers 8 wird dieses Licht in die Single-Mode-Wellenleiter 13a bis 13d eingekoppelt. Dabei sind Phasen der an den Ausgängen 12a bis 12d in die Wellenleiter 13a bis 13d eingekoppelten Lichtwellen relativ zueinander zeitlich konstant und durch die Geometrie des ersten MMI-Kopplers 8 definiert. Im vorliegenden Beispiel soll eine Phasendifferenz an benachbarten Ausgängen der Ausgänge 12a bis 12d jeweils 90° betragen. Durch die Single-Mode-Wellenleiter 13a bis 13d wird dieses Licht zu den Eingängen 14a bis 14d des zweiten MMI-Kopplers 9 geführt, wobei die Phasen der durch die Wellenleiter 13a bis 13d geführten und an den Eingängen 14a bis 14d ankommenden Lichtwellen in Abhängigkeit von einer Ansteuerung der Phasenschieber 11a bis 11d jeweils veränderbar sind und abhängig davon, welcher der Resonatoren aktiviert werden soll, eingestellt werden. Durch das Einkoppeln des in den Wellenleitern 13a bis 13d geführten Lichtes in den zweiten MMI-Koppler 9 über die Eingänge 14a bis 14d werden optische Moden des zweiten MMI-Kopplers 9 angeregt. Eine Anregung der optischen Moden des zweiten MMI-Kopplers 9 ist abhängig von einer Geometrie des MMI-Kopplers 9, insbesondere von einer Anordnung der Eingänge 14a bis 14d an der ersten Seite 32 des zweiten MMI-Kopplers 9 sowie von relativen Phasen der an den Eingängen 14a bis 14d aus den Wellenleitern 13a bis 13d in den zweiten MMI-Koppler 9 eingekoppelten Lichtkomponenten.

Insbesondere sind die optischen Moden des zweiten MMI-Kopplers durch entsprechende Ansteuerung der Phasenschieber 11a bis 11d derart anregbar, das jeweils nur an genau einem der Ausgänge 10a bis 10d des zweiten MMI-Kopplers 9 Licht in einen der Wellenleiter 25a bis 25d ausgekoppelt wird. Mit anderen Worten kann das in der Verstärkersektion 2 erzeugte und in den Wellenleitern 13a bis 13d geführte kohärente Licht durch Ansteuerung der Phasenschieber 11a bis 11d im zweiten MMI-Koppler 9 derart zur Interferenz gebracht werden, dass es jeweils an nur genau einem der Ausgänge 10a bis 10d konstruktiv interferiert, während eine Interferenz an den übrigen der Ausgänge 10a bis 10d jeweils destruktiv ist. Die Verbindungssektion 5, welche die MMI-Koppler 8 und 9, die Wellenleiter 13a bis 13d sowie die Phasenschieber 11a bis 11d umfasst, ist also eingerichtet, als ein optischer Schalter zu wirken, mit dem das in der Verstärkersektion 2 erzeugte Licht jeweils auf nur genau einen der Bragg-Reflektoren 7a bis 7a lenkbar ist. Indem beispielsweise die Phasenschieber 11a bis 11d derart angesteuert werden, dass das im aktiven Material 3 erzeugte Licht nur auf den ersten Reflektor 7a gelenkt wird, wird der Laser 1 auf den ersten optischen Resonator geschaltet, der durch den optischen Ausgang 4 und durch den ersten Reflektor 7a begrenzt ist. In gleicher Weise kann das Licht auf einen der anderen Reflektoren 7b, 7c oder 7d geleitet werden und der DBR-Laser 1 dementsprechend auf den zweiten, dritten oder vierten Resonator geschaltet werden.

Das auf diese Weise im erstgenannten Fall am ersten Reflektor 7a reflektierte Licht wird über den Wellenleiter 25a und den ersten Ausgang 10a zurück in den zweiten MMI-Koppler 9 eingekoppelt. Über die Wellenleiter 13a bis 13d, den ersten MMI-Koppler 8 und den Wellenleiter 24 gelangt dieses Licht zurück in die Verstärkersektion 2. Bei einem vollständigen Umlauf im ersten Resonator durchläuft das in der Verstärkersektion 2 erzeugte Licht jeden der MMI-Koppler 8 und 9 also genau zweimal, und zwar jeweils in entgegengesetzter Richtung. In ganz analoger Weise ist der Laser 1 durch Ansteuerung der Phasenschieber 11a bis 11d auf den zweiten, den dritten oder den vierten Resonator umschaltbar. Die Emissionswellenlänge des Lasers 1 ist also zum einen durch die Ansteuerung der Phasenschieber 11a bis 11d und zum anderen durch das Reflexionsspektrum desjenigen der Reflektoren 7a bis 7d definiert, auf den das in der Verstärkersektion 2 emittierte Licht jeweils gelenkt wird. Dabei sind die Reflexionsspektren der Reflektoren 7a bis 7d mittels der an den Reflektoren 7a bis 7d jeweils angeordneten Verstimmelemente zusätzlich in der oben beschriebenen Weise unabhängig voneinander veränderbar, und zwar jeweils in hinreichend weiten Grenzen, um insgesamt ein stufenloses Verstimmen über ein verhältnismäßig großes Wellenlängenintervall zu ermöglichen. Die jeweils durch Verstimmen der einzelnen Reflektoren 7a bis 7d durchfahrbaren Intervalle überlappen sich dazu.

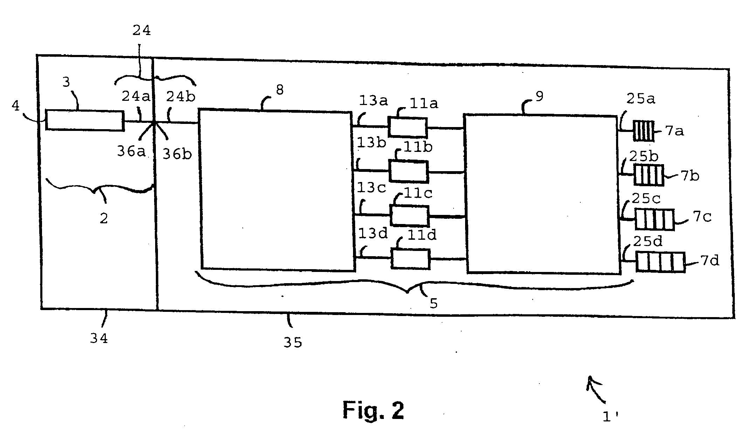

Figur 2 zeigt eine zweite Ausführungsform eines hier in Hybridintegration realisierten DBR-Lasers 1'. Dabei sind wiederkehrende Merkmale hier und im Folgenden jeweils mit identischen Bezugszeichen versehen. Die in Figur 2 gezeigte zweite Ausführungsform unterscheidet sich von der in Figur 1 gezeigten ersten Ausführungsform lediglich dadurch, dass die Verbindungssektion 2 auf einem ersten Substrat 34 aus Silizium angeordnet ist, während die Verbindungssektion 5 mit dem ersten MMI-Koppler 8 und dem zweiten MMI-Koppler 9 sowie die Wellenlängenselektiven Bragg-Reflektoren 7a bis 7d auf einem zweiten Substrat 35 angeordnet sind, wobei das zweite Substrat aus einem Polymer gebildet ist. Auch hier ist das aktive Material 3 über den Single-Mode-Wellenleiter 24 mit dem Eingang 23 des ersten MMI-Kopplers 8 verbunden. Die Substrate 34 und 35 grenzen unmittelbar aneinander an, so dass ein erster Abschnitt 24a des Single-Mode-Wellenleiters 24 auf dem ersten Substrat 34 und ein zweiter Abschnitt 24b des Wellenleiters 24 auf dem zweiten Substrat 35 verläuft. Zur Vermeidung von Reflexionen an einer Grenzschicht zwischen dem ersten Abschnitt 24a und dem zweiten Abschnitt 24b des Wellenleiters 24 sind ein der Verbindungssektion 5 zugewandtes Ende 36a des ersten Abschnitts 24a sowie ein der Verstärkersektion 2 zugewandtes Ende 36b des zweiten Abschnitts 24b jeweils entspiegelt. Hier sollen der erste Abschnitt 24a und der zweite Abschnitt 24b des Wellenleiters 24 jeweils als Rippenwellenleiter ausgebildet sein, die jeweils auf Oberflächen der Substrate 34 und 35 angeordnet sind. Bei einer leicht abgewandelten Ausführungsform kann es vorgesehen sein, dass der Wellenleiter 24 zur optischen Kopplung der auf unterschiedlichen Substraten angeordneten Verstärkersektion 2 und Verbindungssektion 5 als optische Single-Mode-Faser ausgebildet ist.

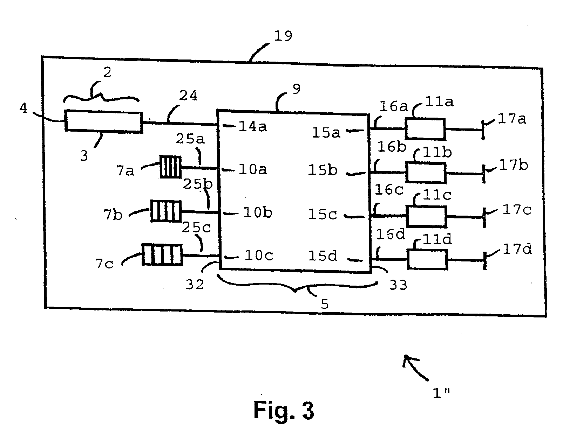

Figur 3 schließlich zeigt eine dritte Ausführungsform des hier mit 1" bezeichneten DBR-Lasers, bei welcher wiederum sämtliche Komponenten auf dem Siliziumsubstrat 19 angeordnet sind. Diese Ausführungsform unterscheidet sich von den vorher gezeigten dadurch, dass die Verbindungssektion 5 nur einen MMI-Koppler 9 aufweist. Die Ausgänge 10a bis 10c des MMI-Kopplers 9 sind in Figur 3 an derselben ersten Seite 32 des MMI-Kopplers 9 angeordnet wie der Eingang 14a. Über Single-Mode-Wellenleiter 25a bis 25c ist jeder der Ausgänge 10a bis 10c mit genau einem von drei verschiedenen wellenlängenselektiven Bragg-Reflektoren 7a bis 7c verbunden. Zusätzlich weist der MMI-Koppler 9 in Figur 3 vier weitere Ausgänge 15a bis 15d auf, die den mit den wellenlängenselektiven Reflektoren 7a bis 7c verbundenen Ausgängen 10a bis 10c und dem Eingang 14a des MMI-Kopplers 9 gegenüberliegen. Die weiteren Ausgänge 15a bis 15d sind also an einer zweiten Seite 33 des MMI-Kopplers 9 angeordnet, wobei die zweite Seite 33 der ersten Seite 32 gegenüberliegt.

Die weiteren Ausgänge 15a bis 15d sind jeweils durch Single-Mode-Wellenleiter 16a bis 16d mit genau einem von vier in den jeweiligen Wellenleiter 16a bis 16d zurückreflektierenden Spiegeln 17a bis 17d verbunden. Vorliegend sind die Spiegel 17a bis 17d jeweils als Facetten, das heißt als abschließende Flächen der Single-Mode-Wellenleiter 16a bis 16d ausgebildet. Das an den Spiegeln 17a bis 17d reflektierte Licht wird an den weiteren Ausgängen 15a bis 15d wieder in den MMI-Koppler 9 eingekoppelt.

In einem Verlauf jedes der Single-Mode-Wellenleiter 16a bis 16d ist jeweils genau einer von vier Phasenschiebern 11a bis 11d angeordnet. Mittels der Phasenschieber 11a bis 11d sind optische Weglängen der Wellenleiter 16a bis 16d jeweils veränderbar. Bei der in Figur 3 gezeigten Ausführungsform weisen die Phasenschieber 11a bis 11d jeweils als unmittelbar an den jeweiligen Wellenleiter 16a, 16b, 16c bzw. 16d angeordnete Elektrodenpaare auf, an denen jeweils elektrische Spannungen anlegbar sind.

Die wellenlängenselektiven Reflektoren 7a bis 7c sind also auch hier durch die Verbindungssektion 5 optisch mit der Verstärkersektion 2 gekoppelt. Reflexionsspektren der wellenlängenselektiven Reflektoren 7a bis 7c sind jeweils unterschiedlich. Insbesondere liegen Maxima der Reflexionsspektren der Reflektoren 7a bis 7c jeweils bei unterschiedlichen Wellenlängen. Die Phasenschieber 11a bis 11d sind unabhängig voneinander ansteuerbar. Durch Ansteuerung mindestens eines der Phasenschieber 11a bis 11d ist der DBR-Laser 1" zwischen einem ersten optischen Resonator, einem zweiten optischen Resonator und einem dritten optischen Resonator umschaltbar. Der erste optische Resonator wird durch einen teilreflektierenden optischen Ausgang 4 der Verstärkersektion 2 und durch den ersten wellenlängenselektiven Reflektor 7a begrenzt. Der zweite optische Resonator wird durch den optischen Ausgang 4 und durch den zweiten wellenlängenselektiven Reflektor 7b begrenzt. Der dritte optische Resonator wird durch den optischen Ausgang 4 und durch den dritten wellenlängenselektiven Reflektor 7c begrenzt.

Die Phasenschieber 11a bis 11d sind derart ansteuerbar, dass das in der Verstärkersektion 2 erzeugte und von der Verstärkersektion 2 aus über den Wellenleiter 24 am Eingang 14a in den MMI-Koppler 9 eingekoppelte Licht frei wählbar auf genau einen der wellenlängenselektiven Reflektoren 7a bis 7c lenkbar ist. Durch das Lenken dieses Lichtes auf jeweils nur genau einen der Reflektoren 7a bis 7c wird der DBR-Laser 1" auf den von diesem Reflektor 7a, 7b oder 7c begrenzten optischen Resonator geschaltet und emittiert dementsprechend mit einer durch das Reflexionsspektrum dieses Reflektors 7a, 7b oder 7c definierten Wellenlänge.

Bei der in Figur 3 gezeigten dritten Ausführungsform, die sich durch eine besondere Kompaktheit auszeichnet, durchläuft das in der Verstärkersektion 2 erzeugte Licht den MMI-Koppler 9, die Wellenleiter 16a bis 16d und die Phasenschieber 11a bis 11d bei einem vollständigen Umlauf in dem jeweils ausgewählten optischen Resonator jeweils genau viermal. So wird das in der Verstärkersektion 2 erzeugte Licht zunächst am Eingang 14a in den MMI-Koppler 9 eingekoppelt und von dort aus über die weiteren Ausgänge 15a bis 15d und die Wellenleiter 16a bis 16d auf die Spiegel 17a bis 17d geleitet. Nach Reflexion an den Spiegeln 17a bis 17d wird das Licht jeweils in die Wellenleiter 16a bis 16d zurückreflektiert und von den Wellenleitern 16a bis 16d an den weiteren Ausgängen 15a bis 15d wiederum in den MMI-Koppler 9 eingekoppelt. Optische Phasen des in den Wellenleitern 16a bis 16d geführten kohärenten Lichtes werden dabei mittels Ansteuerung der Phasenschieber 11a bis 11d derart verändert, dass das Licht nach einem zweiten Durchlauf durch den MMI-Koppler 9 z. B. nur am Ausgang 10a konstruktiv interferiert, während es an den beiden anderen Ausgängen 10b und 10c destruktiv interferiert. Durch andere Ansteuerung kann analog erreicht werden, dass sich nur am Ausgang 10b oder nur am Ausgang 10c konstruktive Interferenz ergibt. Damit wird das Licht nach dem zweiten Durchlauf durch den MMI-Koppler 9 im ersten Fall nur auf den ersten wellenlängenselektiven Reflektor 7a gelenkt. Nach Reflektion - im beispielhaft genannten Fall - am ersten Reflektor 7a wird das Licht am Ausgang 10a wiederum in den MMI-Koppler 9 eingekoppelt und durchläuft diesen sowie die Wellenleiter 16a bis 16d ein drittes Mal. Nach einer zweiten Reflektion an den Spiegeln 17a bis 17d durchläuft das Licht die Wellenleiter 16a bis 16d und den MMI-Koppler 9 ein viertes Mal, wobei das Licht am Eingang 14a wiederum in den Wellenleiter 24 und über diesen zurück in die Verstärkersektion 2 geführt wird.

Der erste Resonator umfasst also die Verstärkersektion 2, den Wellenleiter 24, den MMI-Koppler 9, die Wellenleiter 16a bis 16d mit den in ihrem Verlauf jeweils angeordneten Phasenschiebern 11a bis 11d, die Spiegel 17a bis 17d sowie den Wellenleiter 25a und den wellenlängenselektiven Reflektor 7a. Der zweite Resonator umfasst anstelle des Wellenleiters 25a und des ersten Reflektors 7a den Wellenleiter 25b und den zweiten Reflektor 7b. Entsprechend umfasst der dritte Resonator gegenüber dem ersten Resonator anstelle des Wellenleiters 25a den Wellenleiter 25c und anstelle des ersten Reflektors 7a den dritten Reflektor 7c.

Der DBR-Laser 1 emittiert am optischen Ausgang 4 also jeweils Laserlicht einer Emissionswellenlänge, die in Abhängigkeit vom Reflexionsspektrum des jeweils ausgewählten Reflektors aus einem breiteren Gewinnspektrum der Verstärkersektion 2 selektiert wird. Über die Verstimmbarkeit der einzelnen wellenlängenselektiven Reflektoren 7a, 7b, 7c gilt das zu den vorherigen Ausführungsbeispielen Gesagte entsprechend.

## Patentansprüche

1. Stimmbarer DBR-Laser (1; 1'; 1"), umfassend eine ein aktives Material (3) enthaltende Verstärkersektion (2), einen teilreflektierenden optischen Ausgang (4), eine Verbindungssektion (5), die sich an einem dem Ausgang (4) des DBR-Lasers (1) gegenüberliegenden Ende (6) der Verstärkersektion (2) an die Verstärkersektion (2) anschließt, einen durch die Verbindungssektion (5) optisch mit der Verstärkersektion (2) gekoppelten wellenlängenselektiven Reflektor (7a, 7b, 7c, 7d) und mindestens einen weiteren wellenlängenselektiven Reflektor (7a, 7b, 7c, 7d), der ebenfalls durch die Verbindungssektion (5) optisch mit der Verstärkersektion (2) gekoppelt ist, wobei die Verbindungssektion (5) mindestens einen MMI-Koppler (9) und mehrere Wellenleiter (13a, 13b, 13c, 13d; 16a, 16b, 16c, 16d) umfasst, wobei in einem Verlauf mindestens eines dieser Wellenleiter (13a, 13b, 13c, 13d; 16a, 16b, 16c, 16d) ein Phasenschieber (11a, 11b, 11c, 11d) angeordnet ist und wobei die wellenlängenselektiven Reflektoren (7a, 7b, 7c, 7d) sich durch unterschiedliche Reflexionsspektren voneinander unterscheiden und mit jeweils einem von mehreren Ausgängen (10a, 10b, 10c, 10d) des mindestens einen MMI-Kopplers (9) verbunden sind,
**dadurch gekennzeichnet,**
**dass** die Wellenleiter (13a, 13b, 13c, 13d; 16a, 16b, 16c, 16d) so nebeneinander verlaufen, dass von der Verstärkersektion (2) zu jedem der Reflektoren (7a, 7b, 7c, 7d) jeweils verschiedene optische Wege durch den mindestens einen MMI-Koppler und jeweils einen der Wellenleiter (13a, 13b, 13c, 13d; 16a, 16b, 16c, 16d) führen, wobei der DBR-Laser (1) durch Ansteuerung des mindestens einen Phasenschiebers (11a, 11b, 11c, 11d) umschaltbar ist zwischen verschiedenen Resonatoren, die durch jeweils einen der wellenlängenselektiven Reflektoren (7a, 7b, 7c, 7d) begrenzt sind, wobei
(a) die Verbindungssektion (5) einen ersten MMI-Koppler (8) und einen zweiten MMI-Koppler (9) enthält, wobei Ausgänge des ersten MMI-Kopplers (8) durch die nebeneinander verlaufenden Wellenleiter (13a, 13b, 13c, 13d) mit jeweils einem von mehreren Eingängen (14a, 14b, 14c, 14d) des zweiten MMI-Kopplers (9) verbunden sind und wobei die wellenlängenselektiven Reflektoren (7a, 7b, 7c, 7d) mit jeweils einem von mehreren Ausgängen (10a, 10b, 10c, 10d) des zweiten MMI-Kopplers (9) verbunden sind,
oder
(b) der mindestens eine MMI-Koppler (9) mindestens zwei weitere Ausgänge (15a, 15b, 15c, 15d) aufweist, die den mit den wellenlängenselektiven Reflektoren (7a, 7b, 7c) verbundenen Ausgängen (10a, 10b, 10c) dieses MMI-Kopplers (9) gegenüberliegen und die jeweils durch einen der nebeneinander verlaufenden Wellenleiter (16a, 16b, 16c, 16c) mit einem in den jeweiligen Wellenleiter (16a, 16b, 16c, 16c) zurückreflektierenden Spiegel (17a, 17b, 17c, 17d) verbunden sind, wobei die Verstärkersektion (2) optisch mit einem Eingang (14a) dieses MMI-Kopplers (9) gekoppelt ist, der vorzugsweise den genannten weiteren Ausgängen (15a, 15b, 15c, 15d) gegenüberliegt.

2. DBR-Laser (1; 1'; 1") nach Anspruch 1, **dadurch gekennzeichnet, dass** der mindestens eine MMI-Koppler (9) ein N×N-Koppler ist.

3. DBR-Laser (1; 1'; 1") nach einem der vorherigen Ansprüche, **dadurch gekennzeichnet, dass** der mindestens eine Phasenschieber (11a, 11b, 11c, 11d) ein Heizelement aufweist und/oder als elektrooptisches Element ausgebildet ist.

4. DBR-Laser (1, 1") nach einem der vorherigen Ansprüche, **dadurch gekennzeichnet, dass** der DBR-Laser (1) ein Halbleitersubstrat (19) aufweist, auf dem zumindest die Verstärkersektion (2) angeordnet ist, wobei vorzugsweise das Halbleitersubstrat (19) und/oder mindestens ein auf dem Halbleitersubstrat (19) angeordneter Wellenleiter und/oder der mindestens eine MMI-Koppler (9) zumindest teilweise aus InP oder InGaAsP oder InGaAlAs gebildet ist.

5. DBR-Laser (1; 1'; 1") nach einem der vorherigen Ansprüche, **dadurch gekennzeichnet, dass** das aktive Material (3) ein Halbleitermaterial ist und vorzugsweise InP und/oder InGaAsP und/oder InGaAlAs enthält.

6. DBR-Laser (1') nach einem der vorherigen Ansprüche, **dadurch gekennzeichnet, dass** die Verstärkersektion (2) und die Verbindungssektion (5) auf unterschiedlichen Substraten (34, 35) angeordnet sind, wobei vorzugsweise ein der Verbindungssektion (5) zugewandtes Ende (36a) der Verstärkersektion (2) und/oder ein der Verstärkungssektion (2) zugewandtes Ende (36b) der Verbindungssektion (5) entspiegelt ist.

7. DBR-Laser (1; 1'; 1") nach einem der vorherigen Ansprüche, **dadurch gekennzeichnet, dass** eine Reflektivität des teilreflektierenden optischen Ausgangs (4) bei einer Emissionswellenlänge des DBR-Lasers (1) wenigstens 75 Prozent und/oder höchstens 95 Prozent beträgt.

8. DBR-Laser (1; 1'; 1") nach einem der vorherigen Ansprüche, **dadurch gekennzeichnet, dass** mindestens einer der wellenlängenselektiven Reflektoren (7a, 7b, 7c, 7d) stufenlos stimmbar ist, so dass das Reflexionsspektrum dieses Reflektors (7a, 7b, 7c, 7d) veränderbar ist.

9. Verfahren zum Betreiben eines DBR-Lasers (1; 1'; 1") nach einem der vorhergehenden Ansprüche, wobei der mindestens eine Phasenschieber (11a, 11b, 11c, 11d) derart angesteuert wird, dass in der Verstärkersektion (2) erzeugtes und von der Verstärkersektion (2) aus in die Verbindungssektion (5) eingekoppeltes Licht nur auf genau einen der wellenlängenselektiven Reflektoren (7a, 7b, 7c, 7d) gelenkt wird, so dass der DBR-Laser (1) Laserlicht einer Emissionswellenlänge emittiert, die in Abhängigkeit vom Reflexionsspektrum dieses ausgewählten Reflektors (7a, 7b, 7c, 7d) selektiert wird aus einem Gewinnspektrum der Verstärkersektion (2), das breiter ist als dieses Reflexionsspektrum.

## Claims

1. A tuneable DBR laser (1; 1', 1") comprising an amplifier section (2) containing an active material, a part-reflecting optical output (4), a connection section (5) which at an end (6) of the amplifier section (2) which lies opposite the output (4) of the DBR laser (1) connects to the amplifier section (2), and a wavelength-selective reflector (7a, 7b, 7c, 7d) which is optically coupled to the amplifier section (2) by way of the connection section (5), and at least one further wavelength selective reflector (7a, 7b, 7c, 7d), which is optically coupled to the amplifier section (2) likewise by way of the connection section (5), wherein the connection section (5) comprises at least one MMI coupler (9) and several wave guides (13a, 13b, 13c, 13d; 16a, 16b, 16c, 16d), wherein a phase shifter (11a, 11b, 11c, 11d) is arranged in a course of at least one of these wave guides (13a, 13b, 13c, 13d; 16a, 16b, 16c, 16d) and wherein the wavelength-selective reflectors (7a, 7b, 7c, 7d) differ from one another by way of different reflection spectra and are in each case connected to one of several outputs (10a, 10b, 10c, 10d) of the at least one MMI coupler (9),
**characterised in that**
the waveguides (13a, 13b, 13c, 13d; 16a, 16b, 16c, 16d) are running next to one another, so that in each case different optical paths lead from the amplifier section (2) to each of the reflectors (7a, 7b, 7c, 7d), through the at least one MMI coupler and in each case one of the waveguides (13a, 13b, 13c, 13d; 16a, 16b, 16c, 16d), wherein the DBR laser (1) by way of activating the at least one phase shifter (11a, 11b, 11c, 11d) can be switched over between different resonators which are delimited in each case by one of the wavelength-selective reflectors (7a, 7b, 7c, 7d),
wherein
(a) the connection section (5) comprises a first MMI coupler (8) and a second MMI coupler (9), wherein outputs of the first MMI coupler (8) are connected by way of the waveguides (13a, 13b, 13c, 13d) running next to one another, in each case to one of several inputs (14a, 14b, 14c, 14d) of the second MMI coupler (9) and wherein the wavelength-selective reflectors (7a, 7b, 7c, 7d) are connected in each case to one of several outputs (10a, 10b, 10c, 10d) of the second MMI coupler (9),
or
(b) the at least one MMI coupler (9) comprises at least two further outputs (15a, 15b, 15c, 15d), the further outputs (15a, 15b, 15c, 15d) lying opposite the outputs (10a, 10b, 10c) of this MMI coupler (9) which are connected to the wavelength-selective reflectors (10a, 10b, 10c) and being connected in each case by way of one of the waveguides (16a, 16b, 16c, 16d) running next to one another to a mirror (17a, 17b, 17c, 17d) which reflects back into the respective waveguide (16a, 16b, 16c, 16d), wherein the amplifier section (2) is optically coupled to an input (14a) of this MMI coupler (9), which preferably lies opposite the mentioned further outputs (15a, 15b, 15c, 15d).

2. A DBR laser (1; 1', 1") according to claim 1, **characterised in that** the at least one MMI coupler (9) is an NxN coupler.

3. A DBR laser (1; 1', 1") according to one of the preceding claims, **characterised in that** the at least one phase shifter (11a, 11b, 11c, 11d) comprises a heating element and/or is designed as an electro-optical element.

4. A DBR laser (1, 1") according to one of the preceding claims, **characterised in that** the DBR laser (1) comprises a semiconductor substrate (19), on which at least the amplifier section (2) is arranged, wherein preferably the semiconductor substrate (19) and/or at least one waveguide arranged on the semiconductor substrate (19) and/or the at least one MMI coupler (9) at least partly is formed from InP or InGaAsP or InGaAlAs.

5. A DBR laser (1; 1', 1") according to one of the preceding claims, **characterised in that** the active material (3) is a semiconductor material and preferably contains InP and/or InGaAsP and/or InGaAlAs.

6. A DBR laser (1') according to one of the preceding claims, **characterised in that** the amplifier section (2) and the connection section (5) are arranged on different substrates (34, 35), wherein preferably an end (36a) of the amplifier section (2) which faces the connection section (5) and/or an end (36b) of the connection section (5) which faces the amplifier section (2) is de-mirrored.

7. A DBR laser (1; 1', 1") according to one of the preceding claims, **characterised in that** a reflectivity of the part-reflecting optical output (4) at an emission wavelength of the DBR laser (1) is at least 75% and/or 95% at the most.

8. A DBR laser (1; 1', 1") according to one of the preceding claims, **characterised in that** at least one of the wavelength-selective reflectors (7a, 7b, 7c, 7d) is continuously tuneable, so that the reflection spectrum of this reflector (7a, 7b, 7c, 7d) can be changed.

9. A method for operating a DBR laser (1; 1', 1") according to one of the preceding claims, wherein the at least one phase shifter (11a, 11b, 11c, 11d) is activated in a manner such that light which is produced in the amplifier section (2) and is coupled out from the amplifier section (2) into the connection section (5) is guided only onto exactly one of the wavelength-selective reflectors (7a, 7b, 7c, 7d), so that the DBR laser (1) emits laser light of an emission wavelength which is selected, in a manner dependent on the reflection spectrum of this selected reflector (7a, 7b, 7c, 7d), from a gain spectrum of the amplifier section (2), which is broader than this reflection spectrum.

## Revendications

1. Laser DBR accordable (1 ; 1' ; 1") comprenant une section d'amplification (2) contenant une matière active (3), une sortie optique (4) partiellement réfléchissante, une section de liaison (5), qui est raccordée, au niveau d'une extrémité (6) de la section d'amplification (2), opposée à la sortie (4) du laser DBR (1), à la section d'amplification (2), un réflecteur sélectif de longueurs d'ondes (7a, 7b, 7c, 7d) couplé optiquement avec la section d'amplification (2) par la section de liaison (5) et au moins un réflecteur sélectif de longueurs d'ondes (7a, 7b, 7c, 7d) supplémentaire, qui est également couplé optiquement avec la section d'amplification (2) avec la section de liaison (5), la section de liaison (5) comprenant au moins un coupleur MMI (9) et plusieurs guides d'ondes (13a, 13b, 13c, 13d ; 16a, 16b, 16c, 16d), un déphaseur (11a, 1b, 11c, 11d) étant disposé dans le trajet d'au moins un de ces guides d'ondes (13a, 13b, 13c, 13d ; 16a, 16b, 16c, 16d) et les réflecteurs sélectifs de longueurs d'ondes (7a, 7b, 7c, 7d) se distinguant les uns des autres par différents spectres de réflexion et étant reliés chacun avec un parmi plusieurs sorties (10a, 10b, 10c, 10d) de l'au moins un coupleur MMI (9),
**caractérisé en ce que**
les guides d'ondes (13a, 13b, 13c, 13d ; 16a, 16b, 16c, 16d) s'étendent les uns à côté des autres de façon à ce que, de la section d'amplification (2) à chacun des réflecteurs (7a, 7b, 7c, 7d), conduisent différents trajets optiques, à travers l'au moins un coupleur MMI et un des guides d'ondes (13a, 13b, 13c, 13d ; 16a, 16b, 16c, 16d), le laser DBR (1) pouvant être commuté, par la commande de l'au moins déphaseur (11a, 11b, 11c, 11d), entre différents résonateurs, qui sont limités chacun un des réflecteurs sélectifs de longueurs d'ondes (7a, 7b, 7c, 7d),
a) la section de liaison (5) contenant un premier coupleur MMI (8) et un deuxième coupleur MMI (9), les sorties du premier coupleur MMI (8) étant reliées, par l'intermédiaire des guides d'ondes (13a, 13b, 13c, 13d ; 16a, 16b, 16c, 16d) s'étendant les uns à côté des autres, chacun avec une parmi plusieurs entrées (14a, 14b, 14c, 14d) du deuxième coupleur MMI (9) et les réflecteurs sélectifs de longueurs d'ondes (7a, 7b, 7c, 7d) étant reliés chacun avec une parmi plusieurs sorties (10a, 10b, 10c, 10d) du deuxième coupleur MMI (9).
ou
b) l'au moins un coupleur MMI (9) comprenant au moins deux sorties supplémentaires (15a, 15b, 15c, 15d), qui font face aux sorties (10a, 10b, 10c, 10d) de ce coupleur (9), reliées avec les réflecteurs sélectifs de longueurs d'ondes (7a, 7b, 7c, 7d) et qui sont reliées chacune, par l'intermédiaire d'un des guides d'ondes (16a, 16b, 16c, 16d) s'étendant les uns à côté des autres, avec un miroir réfléchissant (17a, 17b, 17c, 17d) dans le guide d'ondes (16a, 16b, 16c, 16d), la section d'amplification (2) étant couplée optiquement avec une entrée (14a) de ce coupleur MMI (9), qui fait face de préférence aux sorties supplémentaires (15a, 15b, 15c, 15d) mentionnées.

2. Laser DBR (1 ; 1' ; 1") selon la revendication 1, **caractérisé en ce que** l'au moins un coupleur MMI (9) est un coupleur NxN.

3. Laser DBR (1 ; 1' ; 1") selon l'une des revendications précédentes, **caractérisé en ce que** l'au moins un déphaseur (11a, 11b, 11c, 11d) comprend un élément chauffant et/ou est conçu comme un élément électro-optique.

4. Laser DBR (1 ; 1' ; 1") selon l'une des revendications précédentes, **caractérisé en ce que** le laser DBR (1) comprend un substrat semi-conducteur (19) sur lequel est disposée au moins la section d'amplification (2), de préférence le substrat semi-conducteur (19) et/ou au moins un guide d'ondes disposé sur le substance semi-conducteur (19) et/ou l'au moins un coupleur MMI (9) étant constitué au moins partiellement de InP ou d'InGaAsP ou d'InGaAlAs

5. Laser DBR (1 ; 1' ; 1") selon l'une des revendications précédentes, **caractérisé en ce que** le matériau actif (3) est un matériau semi-conducteur et contient de préférence de l'InP et/ou de l'InGaAsP et/ou de l'InGaAlAs.

6. Laser DBR (1') selon l'une des revendications précédentes, **caractérisé en ce que** la section d'amplification (2) et la section de liaison (5) sont disposées sur différents substrats (34, 35), de préférence une extrémité (36a) de la section d'amplification (2), orientée vers la section de liaison (5) et/ou une extrémité (36b) de la section de liaison (5), orientée vers la section d'amplification (2) étant traitées antireflet.

7. Laser DBR (1 ; 1' ; 1") selon l'une des revendications précédentes, **caractérisé en ce qu'**une réflectivité de la sortie optique partiellement réfléchissante (4) est d'au moins 75% et/ou de 95 % maximum pour une longueur d'onde d'émission du laser DBR (1).

8. Laser DBR (1 ; 1' ; 1") selon l'une des revendications précédentes, **caractérisé en ce qu'**au moins un des réflecteurs sélectifs de longueurs d'ondes (7a, 7b, 7c, 7d) peut être accordé de manière progressive de façon à ce que le spectre de réflexion de ce réflecteur (7a, 7b, 7c, 7d) soit variable.

9. Procédé d'exploitation d'un laser DBR (1 ; 1' ; 1") selon l'une des revendications précédentes, l'au moins un déphaseur (11a, 11b, 11c, 11d) étant contrôlé de façon à ce que la lumière produite dans la section d'amplification (2) et introduite à partir de la section d'amplification (2) vers la section de liaison (5) est déviée uniquement sur exactement un des réflecteurs sélectifs de longueurs d'ondes (7a, 7b, 7c, 7d) de façon à ce que le laser DBR (1) émette une lumière laser d'une longueur d'onde d'émission qui est sélectionnée en fonction du spectre de réflexion de ce réflecteur (7a, 7b, 7c, 7d) sélectionné, dans un spectre de gain de la section d'amplification (2) qui est plus large que ce spectre de réflexion.
